# EUROPEAN PATENT APPLICATION

(11) **EP 2 669 956 A2**
(43) Date of publication of application: **04.12.2013**
(21) Application number: 12739037.5
(22) Date of filing: 20.01.2012
(51) Int. Cl.: H01L 31/042

(54) **SOLAR CELL MODULE**

(30) Priority: 24.01.2011 KR 20110006991
(71) Applicant: LG Innotek Co., Ltd., Seoul 100-714 (KR)
(72) Inventor: PARK, Chi Hong, Seoul 100-714 (KR)
(74) Representative: Novagraaf Technologies
(86) International application number: PCT/KR2012/000544
(87) International publication number: WO 2012/102531

(57) **Abstract**

Disclosed is a solar cell module including substrate, a solar cell panel on one surface of the substrate and a protective layer between the solar cell panel and the substrate. The protective layer is formed in the solar cell module by using vacuum or inert gas, thereby effectively preventing the solar cell module from moisture penetration.

## Description

### [Technical Field]

The embodiment relates to a solar cell module.

### [Background Art]

In general, a solar cell is spotlighted due to energy and environmental problems. In particular, studies on a BIPV (building integrated photovoltaic) module installed at an outer wall of a building have been actively pursued.

A solar cell module according to the related art is used outdoors, so long lifespan and durability are required. In this regard, a filling material, such as an EVA (ethyl vinyl acetate) resin, is applied to the solar cell mode to prevent the solar cell module from moisture penetration and external impact.

However, since the EVA resin is formed of a film material, the EVA resin has limitations against moisture penetration. If moisture penetrates into the solar cell module, the solar cell module may be malfunctioned.

### [Disclosure]

### [Technical Problem]

The embodiment provides a solar cell module capable of preventing moisture penetration

### [Technical Solution]

A solar cell module according to one embodiment includes a substrate, a solar cell panel on one surface of the substrate, and a protective layer between the solar cell panel and the substrate.

### [Advantageous Effects]

The solar cell module according to the embodiment includes a protective layer formed by using vacuum or inert gas, so the solar cell module can effectively prevent moisture penetration.

### [Description of Drawings]

FIG. 1 is a sectional view showing a solar cell module having a protective layer according to the embodiment.

FIG. 2 is a perspective view showing a solar cell panel provided in a solar cell module according to the embodiment.

FIG. 3 is a perspective view showing a CIGS solar cell provided in a solar cell module according to the embodiment.

FIGS. 4 and 5 are sectional views showing modified examples of a solar cell according to the embodiment.

### [Best Mode]

### [Mode for Invention]

In the description of the embodiments, it will be understood that when each panel, wire, cell, surface, or pattern is referred to as being "on" or "under" another panel, wire, cell, surface, or pattern, it can be "directly" or "indirectly" on the other panel, wire, cell, surface, or pattern, or one or more intervening layers may also be present. Such a position of elements will be explained with reference to the drawings. The thickness and size of each layer shown in the drawings may be exaggerated for the purpose of explanation. In addition, the size of elements does not utterly reflect an actual size.

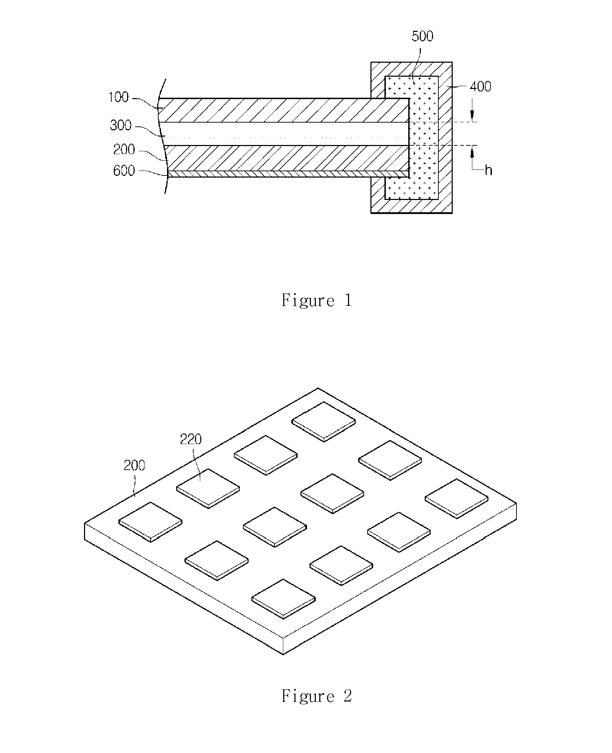

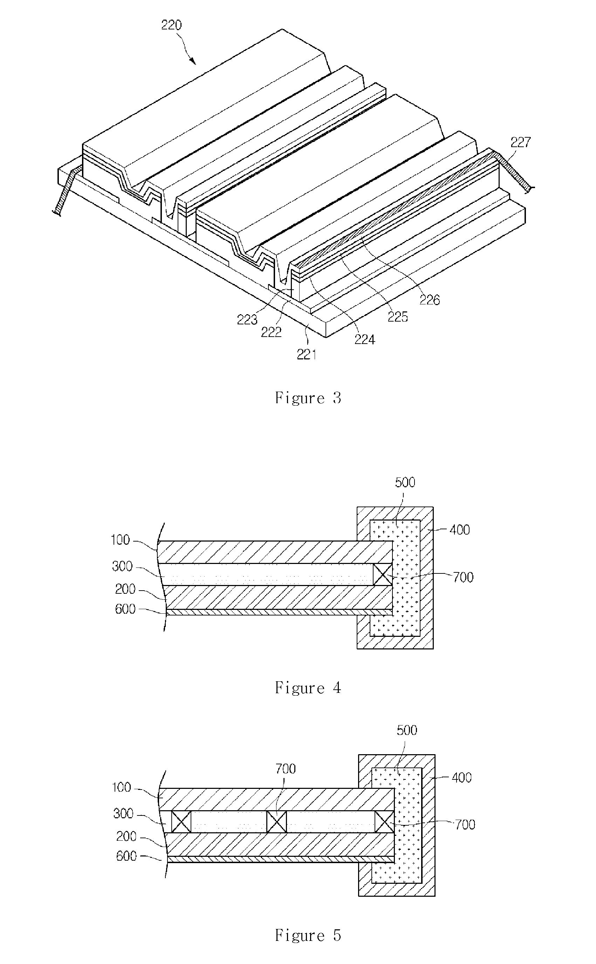

FIG. 1 is a sectional view showing a solar cell module having a protective layer according to the embodiment, FIG. 2 is a perspective view showing a solar cell panel provided in a solar cell module according to the embodiment, FIG. 3 is a perspective view showing a CIGS solar cell provided in a solar cell module according to the embodiment, and FIGS. 4 and 5 are sectional views showing modified examples of a solar cell according to the embodiment.

Referring to FIG. 1, the solar cell module according to the embodiment includes a substrate 100, a solar cell panel 200 provided under the substrate 100, and a protective layer 300 formed between the solar cell panel 200 and the substrate 100. A protective sheet 600 is further formed under the solar cell panel 200 and a frame 500 is further provided at one side of the solar cell panel 200 to surround outer peripheral portions of the substrate 100, the protective layer 300 and the solar cell panel 200.

The substrate 100 has a rectangular plate shape and may be formed of tempered glass having sufficient strength against external impact, such as wind pressure, hailstone or snow load. To this end, preferably, the number of debris generated when the substrate 100 is broken may be set within a predetermined range per a unit area to the extent that the substrate 10 may not be scattered into a plurality of pieces.

Low-iron tempered glass or tempered glass having no iron component is preferably used for the substrate 100 to prevent solar light incident into the solar cell from being reflected to the outside and one side of the substrate 100 may be treated with embossing.

The solar cell panel 200 is provided under the substrate 100. As shown in FIG. 2, a plurality of solar cells 220 are provided on the solar cell panel 200 in the form of a matrix. A CIGS solar cell having superior efficiency and durability is preferably used as the solar cell 220 and the number of the CIGS solar cells 220 provided on the solar cell panel 200 is not limited.

In detail, as shown in FIG. 3, the CIGS solar cells 220 are serially connected with each other in the form of a grid by a metal ribbon and a substrate 221 of the CIGS solar cell 220 may include soda lime glass.

A Mo layer 222 is laminated on the soda lime glass substrate 221 as a back electrode layer and a CIS layer 223 serving as a solar light absorbing layer, a CdS layer 224 serving as a buffer layer, a ZnO layer 225 and an AZO 226 serving as a transparent electrode layer are sequentially laminated on the Mo layer 222. In addition, an upper electrode (not shown) may be connected onto the AZO layer 226 to improve the collection efficiency.

A predetermined region having a predetermined width where the CIGS layer 223 to AZO layer 225 are not formed may be formed on the CIGS solar cell 220 at one side of the Mo layer 222 to allow the Mo layer 222 to be connected with the metal ribbon through the soldering.

Although two CIGS solar cells 220 are illustrated in the drawing for the purpose of convenience of explanation, one or at least three CIGS cells may be provided.

Referring back to FIG. 1, a protective sheet 600 may be further provided under the solar cell panel 200. The protective sheet 600 may include an EVA (ethyl vinyl acetate) sheet or a back sheet. The protective sheet 600 protects the bottom surface of the solar cell panel 200 from external impact or moisture penetration. The back sheet may include a fluorine-based resin.

The EVA or the back sheet may be exclusively used as the protective sheet 600 or both of the EVA and the back sheet may be sequentially laminated to form the protective sheet 600.

Meanwhile, the protective layer 300 according to the embodiment is formed between the substrate 100 and the solar cell panel 200. The protective layer 300 protects the solar cell module from external impact as well as external moisture penetration. In addition, the protective layer 300 may prevent the aging of the solar cell panel 200.

The protective layer 300 may have a height of about 2 mm to about 6 mm and can be formed by injecting vacuum or inert gas between the substrate 100 and the solar cell panel 200. N₂ or Ar is mainly used as the inert gas, but other inert gases can also be used.

If the protective layer 300 is formed between the substrate 100 and the solar cell panel 200, a frame 400 may be further formed at one side of the solar cell panel 200 to confine the protective layer 300 between the substrate 100 and the solar cell panel 200.

The frame 400 has a sectional shape of '⊏' to surround outer peripheral portions of the substrate 100, the protective layer 300, the solar cell panel 200 and the protective sheet 600. The frame 400 may fixedly surround upper peripheral portions, lateral sides and lower peripheral portions of the substrate 100, the protective layer 300, the solar cell panel 200 and the protective sheet 600. The frame 400 may be a metal frame including aluminum, stainless steel or iron.

A sealing material 500 may be further formed inside the frame 400. The sealing material 500 absorbs physical impact applied to the frame to more effectively protect the substrate 100, the protective layer 300, the solar cell panel 200 and the protective sheet 600. In addition, the frame 400 may confine the protective layer 300 between the substrate 100 and the solar cell panel 200 such that vacuum or inert gas may not be leaked to the outside.

As described above, the solar cell module having the protective layer 300 according to the embodiment can be more effectively protected from the external impact and the moisture penetration as compared with the solar cell module according to the related art where a filling material such as EVA or PVB is used as a protective layer.

In addition, the vacuum or inert gas serving as the protective layer 300 prevents the aging of the solar cell so that the life span of the solar cell module can be lengthened.

Although it has been described that the protective layer is formed by injecting the vacuum or the inert gas, the protective layer can also be formed as shown in FIGS. 4 and 5 to more improve protection efficiency against the external impact and the moisture penetration.

As shown in FIG. 4, the solar cell module according to the embodiment includes a substrate 100, a solar cell panel 200 under the substrate 100, a protective layer 300 formed between the solar cell panel 200 and the substrate 100 and a frame 400 accommodating a lateral side of the protective layer 300. Since the structures of the substrate 100, the solar cell panel 200 and the frame 400 have been described above, the following description will be made while focusing on the protective layer 300 according to the embodiment.

The protective layer 300 according to the embodiment is formed between the substrate 100 and the solar cell panel 200 by injecting vacuum or inert gas. The inert gas may include N2 or Ar gas.

In addition, a spacer 700 may be further provided at an edge portion between the substrate 100 and the solar cell panel 200.

The spacer 700 may confine the vacuum or the inert gas, the sealing material 500 that seals the protective layer 300 in the frame 400 may be omitted. However, the sealing member 500 may be necessary to improve the fixing force of the solar cell module.

Preferably, the protective layer 300 has a height of 2 mm to 7 mm and the spacer 700 has a height of 2 mm to 7 mm corresponding to the height of the protective layer 300.

If the height of the protective layer 300 is less than 2 mm, a thickness of the protective layer 300 is narrowed so that an interval between the substrate 100 and the solar cell panel 200 may be insufficient. In this case, the protective layer 300 may not serve as a buffer between the substrate 100 and the solar cell panel 200, so the solar cell panel may be damaged even if weak external impact is applied thereto.

If the height of the protective layer 300 exceeds 7 mm, a greater number of spacers 700 may be required in order to effectively support the substrate 100 and the solar cell panel 200. Thus, light loss may occur to the extent of the area of the spacer 700 and the moisture penetration may occur.

In addition, as shown in FIG. 5, the protective layer 300 is formed between the substrate 100 and the solar cell panel 200 and the spacers 700 may be provided in the protective layer 300 while being spaced apart from each other by a predetermined interval. In the case of the large-size solar cell module, the spacers 700 can protect the solar cell module from the external impact and the moisture penetration and can effectively improve the strength of the solar cell module.

The spacers can be regularly or irregularly disposed between the panel and the solar cell panel and the height of the spacer provided between outermost spacers may also be irregularly formed.

Although an exemplary embodiment of the disclosure has been described for illustrative purposes, those skilled in the art will appreciate that various modifications, additions and substitutions are possible, without departing from the scope and spirit of the invention as disclosed in the accompanying claims.

## Claims

1. A solar cell module comprising:
a substrate;
a solar cell panel on one surface of the substrate; and
a protective layer between the solar cell panel and the substrate.

2. The solar cell module of claim 1, wherein the protective layer is formed by injecting vacuum or inert gas.

3. The solar cell module of claim 2, further comprising a spacer formed at an edge portion between the solar cell panel and the substrate.

4. The solar cell module of claim 3, wherein a plurality of spacers are formed between the solar cell panel and the substrate at a predetermined interval.

5. The solar cell module of claim 3, wherein the spacer comprises an epoxy resin.

6. The solar cell module of claim 1, wherein the protective layer has a height in a range of 2 mm to 7 mm.

7. The solar cell module of claim 1, further comprising a frame formed at one side of the solar cell panel to accommodate a lateral side of the protective layer.

8. The solar cell module of claim 7, further comprising a sealing material formed in the frame.

9. The solar cell module of claim 1, wherein the solar cell panel comprises one or a plurality of CIGS solar cells.

10. The solar cell module of claim 1, further comprising an EVA sheet or a back sheet under the solar cell panel.
